Europäisches Patentamt

European Patent Office

Office européen des brevets

(19)

(11) **EP 1 592 231 A1**

(12) **EUROPEAN PATENT APPLICATION**

(43) Date of publication:
**02.11.2005 Bulletin 2005/44**

(51) Int Cl.$^7$: **H04N 3/15**

(21) Application number: **05251099.7**

(22) Date of filing: **24.02.2005**

(84) Designated Contracting States:
**AT BE BG CH CY CZ DE DK EE ES FI FR GB GR HU IE IS IT LI LT LU MC NL PL PT RO SE SI SK TR**
Designated Extension States:
**AL BA HR LV MK YU**

(30) Priority: **25.02.2004 JP 2004049475**

(71) Applicant: **SHARP KABUSHIKI KAISHA
Osaka 545-8522 (JP)**

(72) Inventor: **Watanabe, Takashi
Soraku-gun Kyoto-fu (JP)**

(74) Representative: **Brown, Kenneth Richard et al
R.G.C. Jenkins & Co.
26 Caxton Street
London SW1H 0RJ (GB)**

(54) **Solid-state image pickup device**

(57)    A solid-state image pickup device has one or more pixels (101) and a voltage generation part (71). The or each pixel has a photodetection diode (111), a signal storage region (18), an insulated-gate field effect transistor (112), and a substrate (11). The voltage generation part (71) applies a specified gate voltage and drain voltage to a gate and a drain, respectively, of the insulated-gate field effect transistor to balance a photocurrent generated at the photodetection diode and a current discharged to the substrate with each other at least during a signal read of the pixel so that the pixel is kept in a steady-state operating status that the photocurrent is flowing to the substrate via the signal storage region steadily.

*Fig. 1A*

*Fig. 1B*

EP 1 592 231 A1

*Fig. 1D*

```
        ↑   ↑   ↑
    ┌───────────────┐
    │    VOLTAGE    │
    │  GENERATION   │
    │    CIRCUIT    │
    └───────────────┘
            (
           7 1
```

## Description

BACKGROUND OF THE INVENTION

The present invention relates to solid-state image pickup devices and, more particularly, to a solid-state image pickup device which is a called threshold-voltage modulation type MOS image sensor.

Recently, amplification type solid-state image pickup devices in which an amplification function is given to individual pixels and in which reading is performed by a scanning circuit have been widely used. Amplification type solid-state image pickup devices include horizontal type solid-state image pickup devices in which an amplification part, a reset part, a pixel selection part and the like are disposed separately from one another in a planar arrangement within a pixel, and vertical type solid-state image pickup devices in which an amplification part, a reset part, a pixel selection part are disposed so as to be stacked in a depthwise direction.

Among the vertical type solid-state image pickup devices, there has been proposed a threshold-voltage modulation type MOS image sensor in which a carrier pocket is provided under the channel region of an optical-signal detection MOS transistor (see JP 11-195778A).

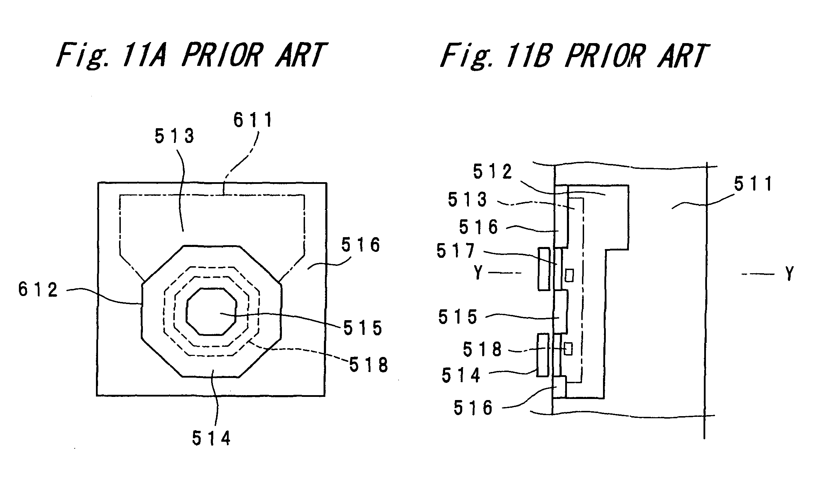

The structure of one pixel of an image sensor of this type is shown in a plan view of Fig. 11A and a sectional view of Fig. 11B. A unit pixel is composed of a photodetection diode 611, an optical-signal detection MOS transistor 612 adjacent to the photodetection diode 611. The unit pixel is formed on an N-type well 512 formed on the top face side of a P-type substrate 511. The photodetection diode 611 and the optical-signal detection MOS transistor 612 are connected to each other by a P-type well 513.

In the optical-signal detection MOS transistor 612, a gate 514 is provided in a ring shape, an N-type source 515 is formed at a center portion, and an N-type drain 516 is formed so as to surround the outer periphery of the gate 514. An N-type layer 517 is formed at a semiconductor surface portion under the gate 514, and the N-type layer 517 forms a channel 517 between the drain 516 and the source 515. Also, under the gate 514 and within a P-type well 513 near the source 515, a P-type hole pocket 518 is provided so as to surround the source 515.

For the threshold-voltage modulation type MOS image sensor, in which the photodetection diode 611 is of a buried photodiode structure, it is implementable to greatly reduce dark current noise. If charge transfer from the photodetection diode 611 to the hole pocket 518 and then to the P-type substrate 511 is perfect, then there is an advantage that reset noise never occurs in principle. However, a great voltage is required to make the charge transfer perfect.

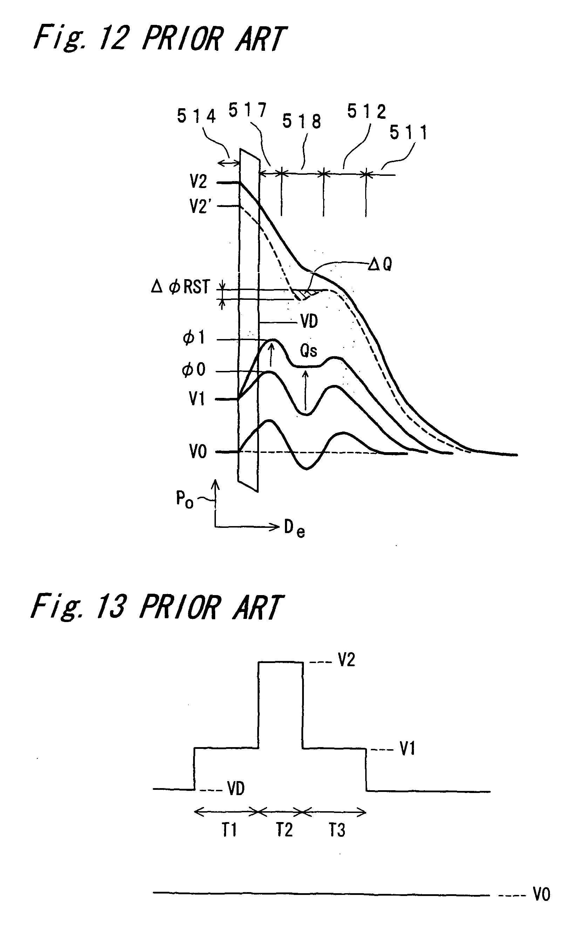

Referring to Fig. 12, operation of the threshold-voltage modulation type MOS image sensor will be explained. In Fig. 12, the vertical axis represents the potential, Po, at a Y-Y section in Fig. 11B, and the horizontal axis represents the depth, De,.

First, in a signal storage operation, the potential of the gate 514 is set to V0, and signal charge (holes) from the photodetection diode 611 is transferred to and stored in the hole pocket region 518. Next, in a signal read operation, the potential of the gate 514 is set to V1 and the potential of the drain 516 is set to VD, by which the potential of the channel (N-type layer) 517 at the surface part is changed according to a signal amount present in the hole pocket 518. That is, the potential becomes φ0 when the signal amount is 0, and the potential becomes φ1 when the signal amount is Qs. This potential change of the channel 517 can be read from the source 515 as an optical signal of the pixel.

Upon completion of the signal read operation, the potential of the gate 514 is set to V2, and the signal charge stored in the hole pocket 518 is discharged to the P-type substrate 511, by which a reset operation is done. After the reset operation, the potential of the gate 514 is set again to V1, so that a pixel reference signal in a state that no signal charge is present in the hole pocket 518 can be read from the source 515. After the reading of the pixel reference signal, the operation procedure enters the signal storage operation once again to carry out the next image pickup operation cycle.

The operation described above is shown in Fig. 13 by a timing chart of the gate voltage. That is, in a period T1, the gate voltage is set to V1, by which an operation of reading an optical signal of the pixel is performed. Next, in a period T2, the gate voltage is set to V2, and the reset operation is performed. Subsequently, in a period T3, the gate voltage is set to V1 again, by which an operation of reading the pixel reference signal is performed. These are repeated for each image pickup operation cycle.

In the above sequence of operations, during the reset operation, if the potential barrier ΔφRST against holes is present over a range of from the hole pocket 518 to the P-type substrate 511, partial charge ΔQ would remain in the hole pocket 518.

As indicated in Fig. 12 in which a voltage V2 and a gate voltage V2' lower than the voltage V2 are shown in a compared manner, the potential barrier ΔφRST and the residual charge amount ΔQ depend on the gate voltage. That is, the potential barrier ΔφRST and the residual charge amount ΔQ decrease as the gate voltage increases. This increase in residual charge amount ΔQ causes afterimages to increase in the picture image.

Further, a signal obtained from the threshold-voltage modulation type MOS image sensor is a linear response to an optical input and would be saturated with intense incident light, so that the dynamic range cannot be made so wide.

SUMMARY OF THE INVENTION

Accordingly, an object of the present invention is to provide a solid-state image pickup device which does not need a large voltage for reset and which is capable of obtaining a wide dynamic range.

In order to accomplish the above object, a solid-state image pickup device according to the present invention has:

at least one pixel having a photodetection diode, a signal storage region for storing therein signal charge derived from the photodetection diode, an insulated-gate field effect transistor for reading, as an output signal, a channel potential which varies depending on a charge amount present in the signal storage region, and a substrate which serves as a discharge destination of the charge present in the signal storage region; and
a voltage generation part for applying a specified gate voltage and drain voltage to a gate and a drain, respectively, of the insulated-gate field effect transistor to balance a photocurrent generated at the photodetection diode and a current discharged to the substrate with each other at least during a signal read of the pixel so that the pixel is kept in a steady-state operating status that the photocurrent is flowing to the substrate via the signal storage region steadily.

In the solid-state image pickup device, the voltage generation part applies the specified gate voltage and drain voltage to the gate and the drain, respectively, of the insulated-gate field effect transistor to thereby balance the photocurrent generated at the photodetection diode and the current discharged to the substrate with each other and keep the pixel in the steady-state operating status in which the photocurrent flows to the substrate via the signal storage region steadily. In the steady-state operating status, the channel potential is read from the insulated-gate field effect transistor, by which an output signal resulting from logarithmic conversion of the photocurrent can be obtained. That is, in the solid-state image pickup device of the invention, a read operation is performed under a steady-state operating status that the photocurrent is steadily flowing to the substrate via the signal storage region.

In this invention, by the reading under the steady-state operating status, the need for performing the reset operation involving such a large gate voltage as would be required conventionally is eliminated and moreover the read operation is a logarithmic conversion operation so that the dynamic range can be broadened.

In one embodiment, the solid-state image pickup device has a plurality of the pixels that are two-dimensionally arrayed. And, the voltage generation part:

in a non-read period, gives a first potential as a gate voltage to the gates of the insulated-gate field effect transistors of all the pixels so that all the pixels are brought into the steady-state operating status, and in a read period, gives the first potential as a gate voltage to the gates of the insulated-gate field effect transistors of pixels of a selected row, and moreover gives a second potential as a gate voltage to the gates of the insulated-gate field effect transistors of pixels of non-selected rows, thereby making only the pixels of the selected row readable.

In one embodiment, the first potential given to the gate by the voltage generation part has a value that causes the insulated-gate field effect transistor to be turned on, and the second potential given to the gate by the voltage generation part has a value that causes the insulated-gate field effect transistor to be turned off.

Accordingly, in a selected row in a read operation,, output signals of the pixels in the steady-state operating status can be read out from the ON-state insulated-gate field effect transistors. Meanwhile, in the pixels of a non-selected row in the read operation, readout of output signals is not performed because the insulated-gate field effect transistors are in the OFF state.

In one embodiment, the photodetection diode is a buried photodiode.

Accordingly, in this embodiment, it becomes possible to reduce the dark current generated at the photodetection diode to a large extent, so that the imaging limit on the lower-illuminance side of the logarithmic-conversion type solid-state image pickup device can be expanded.

In one embodiment, in the non-read period, the voltage generation part gives a third potential as a drain voltage to the drains of the insulated-gate field effect transistors of all the pixels. And, in the read period, the voltage generation part gives a fourth potential as a drain voltage to the drains of the insulated-gate field effect transistors of the pixels of the selected row, and moreover gives the third potential as a drain voltage to the drains of the insulated-gate field effect transistors of the pixels of the non-selected rows.

In this embodiment, the voltage generation part gives the fourth potential to the drains of insulated-gate field effect transistors only for the pixels of a selected row in the read operation, thereby bringing the pixels of the selected row into the steady-state operating status, so that the channel potential can be read as an output signal.

The third potential may have a value that causes a channel surface under the gate of the insulated-gate field effect transistor to be charged (filled with charges) and pinned. Also, the fourth potential may have a value that causes the channel surface under the gate of the insulated-gate field effect transistor to be depleted. In this case, occurrence of the dark current at the channel surface is suppressed to a large extent.

In one embodiment, the solid-state image pickup device further has a storage part for storing each of output signals derived from the plurality of pixels in a dark state or while the plurality of pixels are irradiated with specified uniform light, and outputting the output signals as reference signals, and a subtraction part for subtracting, from each of output signals outputted from the pixels during an image pickup time, a corresponding reference signal, and then outputting the thus obtained signals as image pickup signals of the pixels, respectively.

In this embodiment, it becomes possible to obtain imaging signals from which pixel-to-pixel output offset variations have been eliminated.

As apparent from the above description, according to the present invention, low dark current characteristics can be obtained and moreover logarithmic conversion characteristics can be obtained by virtue of the provision of a threshold-voltage modulation type MOS image sensor. As a result of this, the image pickup range is expanded toward the lower-illuminance side by the low dark current characteristics, and moreover the image pickup range is expanded toward the higher-illuminance side by the logarithmic conversion characteristic. Thus, a greatly wide image pickup range can be obtained, making it possible to realize an image sensor of a greatly wide dynamic range.

Other objects, features and advantages of the present invention will be apparent from the following description.

BRIEF DESCRIPTION OF THE DRAWINGS

The present invention will become more fully understood from the detailed description given hereinbelow and the accompanying drawings which are given by way of illustration only, and thus are not intended to limit the present invention, and wherein:

Fig. 1A shows a pixel structure of a logarithmic conversion type image sensor which is a first embodiment of the solid-state image pickup device according to the present invention;
Fig. 1B is a sectional view taken along the line A-A of Fig. 1A;
Fig. 1C is a potential distribution chart along an interconnecting line of positions D-C-B shown in Fig. 1B;
Fig. 1D shows a voltage generation circuit 71 of the image sensor;
Fig. 2 shows optical response characteristics of the pixel shown in Fig. 1A;
Fig. 3 shows the structure of an image sensor of a two-dimensional array as a second embodiment of the solid-state image pickup device of the invention;
Fig. 4 is a timing chart showing operation timing of the two-dimensional image sensor of the second embodiment;
Fig. 5A is a characteristics diagram showing a relationship between the gate voltage VG and the output voltage Vout for explaining the read operation in the second embodiment;
Fig. 5B is a potential distribution chart;
Fig. 6A shows a relationship between the gate voltage VG and the output voltage Vout in a case where the drain voltage is VD1 of H level in a third embodiment of the invention;
Fig. 6B is a potential distribution chart in the case where the drain voltage is VD1 of H level in the third embodiment;
Fig. 7A shows a relationship between the gate voltage VG and the output voltage Vout in a case where the drain voltage is VD2 of L level in a third embodiment of the invention;
Fig. 7B is a potential distribution chart in the case where the drain voltage is VD2 of L level in the third embodiment;
Fig. 8 shows a structure of the third embodiment of the solid-state image pickup device of the invention;
Fig. 9 is a timing chart for explaining operations of the third embodiment;
Fig. 10 shows a structure of a fourth embodiment of the invention;
Fig. 11A is a plan view showing a pixel in a threshold-voltage modulation type MOS image sensor which is a prior art example;
Fig. 11B is a sectional view of the pixel of the prior art example;
Fig. 12 is a potential distribution chart of the prior art example; and
Fig. 13 is an operation timing chart of the prior art example.

DETAILED DESCRIPTION OF THE INVENTION

Hereinbelow, the present invention will be described in detail by embodiments thereof illustrated in the accompanying drawings.

(First Embodiment)

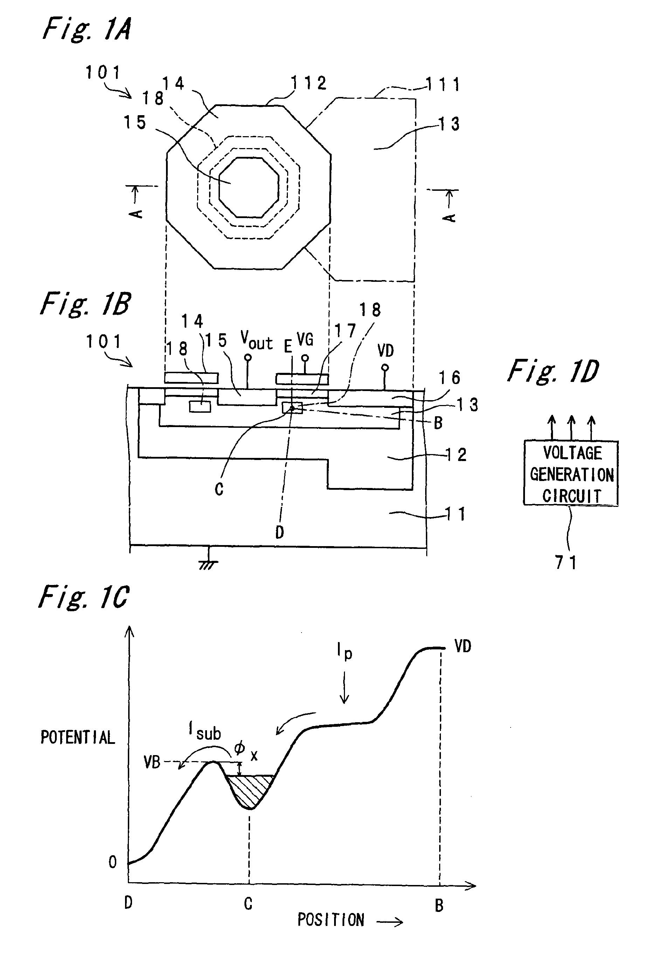

A logarithmic-conversion, threshold-voltage modulation type MOS image sensor which is a first embodiment of the solid-state image pickup device of the present invention will be described with reference to Figs. 1A-1D. Fig. 1A is a plan view of the first embodiment, and Fig. 1B is a sectional view taken along line A-A of Fig. 1A. Fig. 1C is a potential distribution chart along an interconnecting line of positions D-C-B shown in Fig. 1B.

The image sensor of the first embodiment has a pixel 101, which is a unit pixel, and a voltage generation circuit 71 shown in Fig. 1D. The pixel 101 has a photodiode 111, which is a photodetection diode, and an optical-signal detection MOS transistor 112 as an insulated-gate field effect transistor. The optical-signal detection MOS transistor 112 adjoins the photodiode 111.

The pixel 101 is formed on an N-type well 12 formed on the top face side of a P-type substrate 11. The photodetection diode 111 and the optical-signal detection MOS transistor 112 are connected to each other by a P-type well 13.

In the optical-signal detection MOS transistor 112, a gate 14 is generally regular-octagonal ring-shaped, and an N-type source 15 is formed at a center portion. Also, an N-type drain 16 is formed so as to surround the outer periphery of the gate 14. An N-type layer 17 is formed at a semiconductor surface portion under the gate 14, and the N-type layer 17 forms a channel 17 between the drain 16 and the source 15. Also, under the gate 14 and within a P-type well 13 near the source 15, a P-type hole pocket 18 is provided so as to surround the source 15. The hole pocket 18 serves as a charge storage region.

In this first embodiment, the voltage generation circuit 71 first applies a specified drain voltage VD to the drain 16 and a specified gate voltage VG to the ring-shaped gate 14. A potential distribution in this case is shown in Fig. 1C. Referring to Fig. 1C, a photo-charge, i.e. holes in this case, generated at the P-type well 13 of the photodiode 111 is transferred to the hole pocket 18. Thereafter, part of the photo-charge remains in the hole pocket 18, by which the barrier voltage against the P-type substrate 11 becomes φX, causing occurrence of discharge or charge emission through the barrier voltage φX to the P-type substrate 11. A discharge current Isub to the P-type substrate 11 is approximately expressed as a function of the barrier voltage φX by the following Equation (1):

$$Isub = Io \cdot \exp(-\varphi X \cdot q/kT) \qquad (1)$$

where Io is a constant, q is an elementary charge, k is the Boltzmann constant and T is the absolute temperature.

If the state represented by Equation (1) is steadily retained, the photocurrent Ip and the discharge current Isub become equal to each other, so that the following Equation (2) holds eventually:

$$Log(Ip) = -\varphi X \cdot q/kT + Const \qquad (2)$$

where Const is a constant.

Accordingly, there holds a proportional relation between a value resulting from logarithmic conversion of the photocurrent Ip and the barrier voltage φX. As a change in the channel potential of the channel 17 under the ring-shaped gate 14, the value of the barrier voltage φX is read in the form of an output voltage Vout from the source 15.

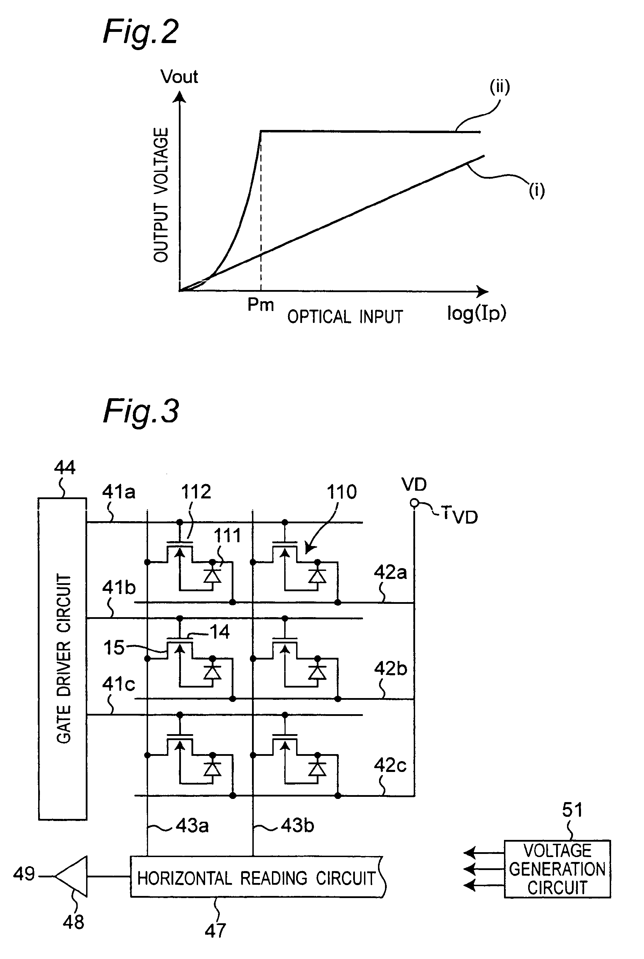

Therefore, in this embodiment, the relationship between the optical input i.e. the logarithm Log(Ip) of the photocurrent Ip and the output voltage Vout results in a linear one, as indicated by an output voltage characteristic (i) shown in Fig. 2. On the other hand, a relationship between the optical input (i.e., the logarithm of the photocurrent) and the output voltage Vout in a conventional linear-conversion type device is such that the output voltage Vout would be saturated when the intensity of incident light reaches Pm, as indicated by an output voltage characteristic (ii) shown in Fig. 2. In contrast to this, according to this embodiment, which is of the logarithmic conversion type, the output voltage characteristic (i) is not saturated, thus making it achievable to enhance the dynamic range to a great extent.

Further, in this first embodiment, the photodiode 111 is of the buried type and therefore dark current noise can be reduced to a large extent. This means that the imaging limit on the lower-illuminance side can be expanded in operations of the logarithmic conversion type.

In this embodiment, the hole pocket 18 as a signal storage region is provided in a generally regular-octagonal shape as shown in Fig. 1A. However, the hole pocket 18 may be formed into a circular, elliptical, rectangular, hexagonal or any other polygonal shape.

(Second Embodiment)

Next, Fig. 3 shows a circuit construction of a logarithmic-conversion, threshold-voltage modulation type MOS image sensor having 2 x 3 two-dimensionally arrayed six pixels 110 as a second embodiment of the solid-state image pickup device of the present invention. Each pixel 110 is similar in structure to the pixel 101 of the foregoing first embodiment, and the optical-signal detection MOS transistor 112 and the photodiode 111 of each pixel 110 are also similar in structure to those of the first embodiment.

Each pixel 110 is composed of a MOS transistor 112 and a photodiode 111. Gates 14 of the MOS transistors 112 of individual rows are connected to a gate driver circuit 44 by gate lines 41a, 41b, 41c, respectively. Also, sources 15 of the MOS transistors 112 of individual columns are connected to a horizontal reading circuit 47 by source lines 43a, 43b, respectively. The horizontal reading circuit 47 is connected to an output circuit 48, and the output circuit 48 is connected to an output terminal 49.

The second embodiment also has a voltage generation circuit 51. The voltage generation circuit 51 is connected to a drain voltage terminal $T_{VD}$ and the gate driver circuit 44. The voltage generation circuit 51 is a circuit for generating a gate voltage VG, which is to be applied to the gates 14 of the individual MOS transistors 112, and a drain voltage VD, which is to be applied to the drains 16.

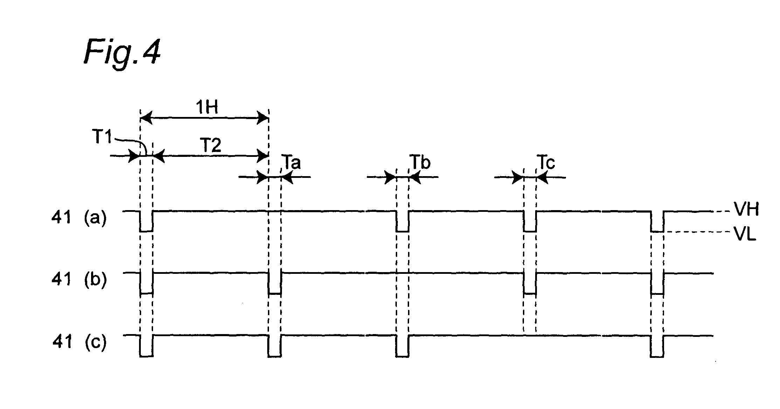

A read operation in this second embodiment will be explained with reference to the timing chart shown in Fig. 4.

As shown in Fig. 4, the gate driver circuit 44 applies gate voltages, which are represented by drive waveforms 41(a), 41(b), 41(c), to the gate lines 41a, 41b, 41c, respectively. One horizontal scan period 1H is composed of a read period T1 and a non-read period T2.

Out of the read periods, in a period Ta during which the gate line 41a is selected, an H level (high level) voltage VH is maintained for the drive waveform 41(a) applied to the gate line 41a, while an L level (low level) voltage VL is applied to the other gate lines 41b, 41c as shown by the drive waveforms 41(b), 41(c). Accordingly, in the period Ta, pixels 110 of rows that are connected to the gate lines 41b, 41c are not selected, so that only the output voltages Vout of pixels 110 of a row that is connected to the gate line 41a are read out by the horizontal reading circuit 47 via the source lines 43a, 43b connected to the sources 15.

Similarly, in a period Tb, the H level voltage VH is applied to the gate line 41b, while the L level voltage VL is applied to the gate lines 41a, 41c. Therefore, only pixels 110 of the row connected to the gate line 41b are selected, and the output voltages Vout are read out by the horizontal reading circuit 47. In a period Tc, the H level voltage VH is applied to the gate line 41c, while the L level voltage VL is applied to the gate lines 41a, 41b. Therefore, only pixels 110 of the row connected to the gate line 41c are selected, and the output voltages Vout are read out by the horizontal reading circuit 47.

Thus, in this second embodiment, in the individual read periods Ta, Tb, Tc, only the gates 14 of the pixels 110 of the row corresponding to the read period Ta, Tb, or Tc, to which the H level voltage VH is applied, are read out, while the L level voltage VL is applied to the gates 14 of the MOS transistors 112 of all the pixels 110 other than pixels to be read (referred to as read-object pixels). In all the non-read periods, the H level voltage VH is applied to the gates 14 of the MOS transistors 112 of all the pixels 110. Thus, in most of the periods, the gates 14 of all the pixels 110 are at the H level voltage VH, so that a steady state in which the photocurrent Ip and the discharge current Isub are coincident with each other is maintained, with the logarithmic conversion type operation lasting. A pixel signal, i.e. output voltage Vout, obtained by the logarithmic conversion type operation is transferred to the horizontal reading circuit 47 via the source lines 43a, 43b, and outputted from the output circuit 48 to the output terminal 49.

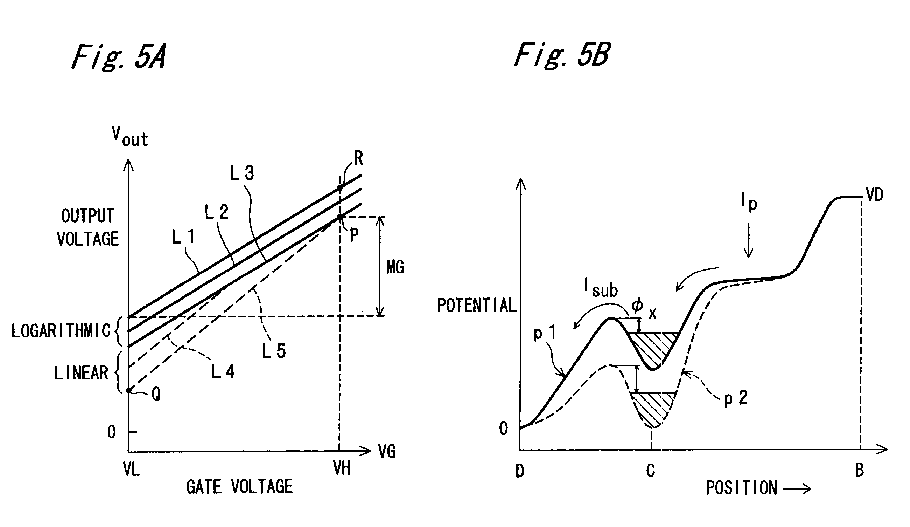

Next, read operation in this second embodiment will be described in detail with reference to Figs. 5A and 5B. Fig. 5A shows a relationship between gate voltage VG and output voltage Vout, and Fig. 5B shows a potential distribution chart taken along a dashed line interconnecting positions D, C, and B of Fig. 1B. Potential distribution p1 drawn by solid line is a potential distribution resulting when the gate voltage VG is the H level voltage VH, and potential distribution p2 drawn by broken line is a potential distribution resulting when the gate voltage VG is the L level voltage VL.

As shown in Fig. 5A, when the gate voltage VG is the H level voltage VH, there is a steady state in which the photocurrent Ip and the discharge current Isub to the substrate are equal to each other. In the steady state, the potential of the hole pocket 18 relative to the substrate 11 rises with increasing light intensity so that the barrier voltage φX decreases logarithmically. As a result, the output voltage Vout increases like characteristics L3, L2, L1 shown in Fig. 5A.

As shown in Fig. 5A, the output voltage Vout varies depending on the gate voltage VG. Also, each VG - Vout curve shifts to logarithmic characteristics L3, L2, L1 in this order as the light intensity increases. The shift amount is in proportion to the logarithm of light intensity.

As the value of the gate voltage VG increases, the barrier voltage φX decreases. Therefore, the hole pocket 18 discharges excess charges to the substrate 11, and the potential distribution is shifted toward such a direction that a new steady state is maintained. That is, the above-described logarithmic-conversion type operation is maintained. Conversely, as the value of the gate voltage VG decreases, the barrier voltage φX increases, whereby the charge stored in the hole pocket 18 prior to the decrease of the gate voltage is preserved. That is, the linear characteristic is maintained.

Accordingly, referring to Fig. 5A, when the gate voltage VG shifts from the H level voltage VH to the L level voltage VL, decreasing from a state P to a state Q, the charge stored in the hole pocket 18 is preserved, and a charge storage operation is started (linear characteristics L4, L5 shown by broken line). After that, however, the gate voltage VG is returned to the H level VH in a short time, when the charge stored in the state Q is all discharged to the substrate 11. Thus, the gate voltage VG is returned to the original steady state P again.

Consequently, as shown in Fig. 4, because the gate voltage VG becomes the L level voltage VL only for a short time of the read period Ta, Tb, Tc, the steady state is maintained by the gate voltage VG returning to the H level voltage VH, so that the logarithmic-conversion type operation is maintained.

In this connection, when the gate 14 of a read-object pixel 110 is set to the H level voltage VH and the gate 14 of a non-read-object pixel 110 is set to the L level voltage VL, an output voltage Vout of the read-object pixel 110 and an output voltage Vout of the non-read-object pixel 110 differ in magnitude from each other by a read margin MG shown in Fig. 5A. This makes it possible to read out only the output voltage Vout of the read-object pixel 110.

In the operation of this second embodiment, since the photodiode 111 serving as a photodetection diode is of the buried type, the dark current that may be generated at the photodiode 111 can be suppressed low.

(Third Embodiment)

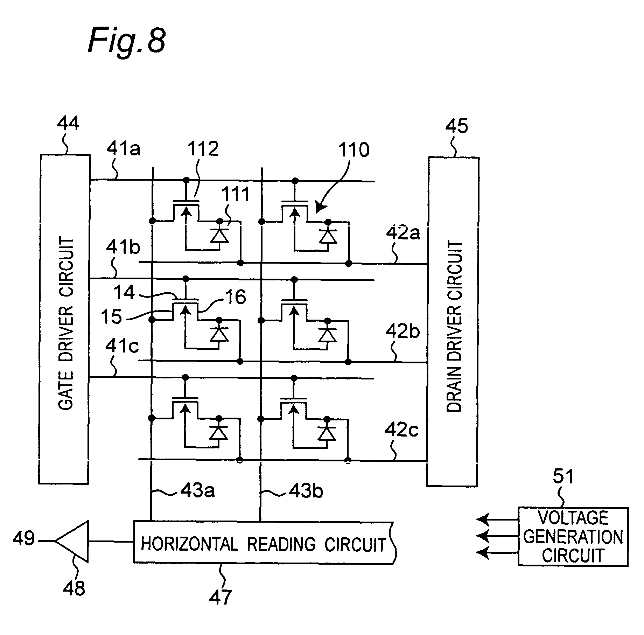

Next, Fig. 8 shows a third embodiment of the solid-state image pickup device of the invention. This third embodiment differs from the foregoing second embodiment in that the solid-state image pickup device of the third embodiment includes a drain driver circuit 45. In the third embodiment, drains 16 of MOS transistors 112 of pixels 110 of individual rows are connected to the drain driver circuit 45 by signal lines 42a, 42b, 42c, respectively.

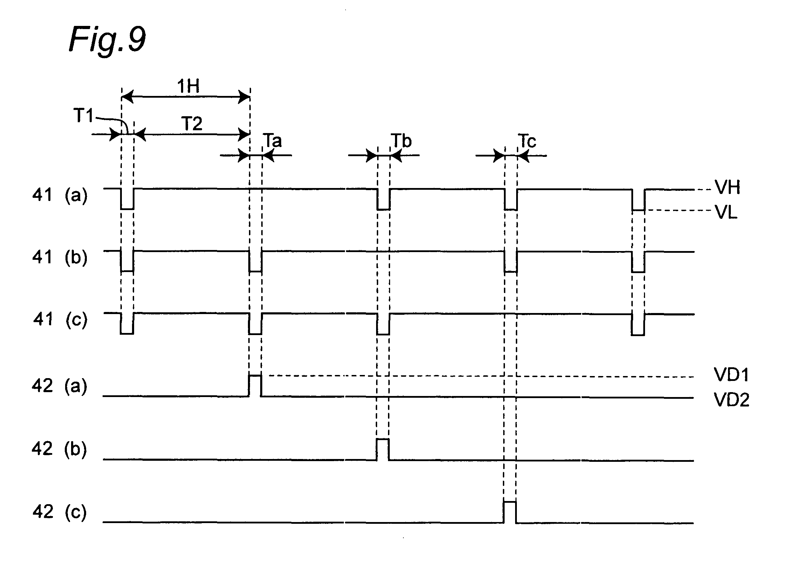

Operation of the third embodiment will be explained with reference to the timing chart of Fig. 9. An upper half of Fig. 9 shows driving waveforms 41(a) to 41(c) of gate voltages applied to gate lines 41a to 41c by the gate driver circuit 44, similar to the foregoing second embodiment. A lower half of Fig. 9 shows waveforms 42(a), 42(b), 42(c) of drain voltages applied to the signal lines 42a, 42b, 42c by the drain driver circuit 45.

In each of the read periods Ta, Tb, Tc, the drain driver circuit 45 applies an H level voltage VD1 only to the signal line 42a, 42b, or 42c of a read-object row. The drain driver circuit 45 applies an L level voltage VD2 to the signal lines 42a to 42c in non-read periods, and further applies the L level voltage VD2 to the signal lines of the rows other than the read-object rows in the read periods Ta to Tc.

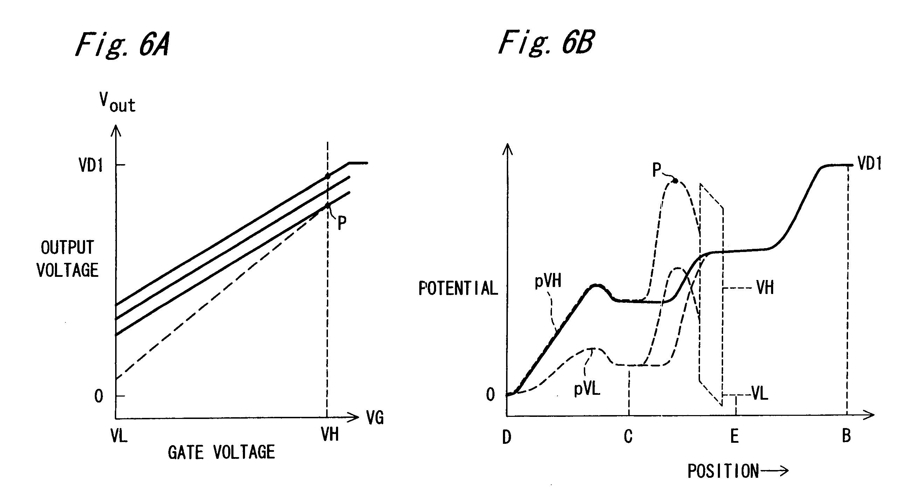

Referring now to Fig. 6B, potential distributions pVH and pVL in an area under the gate electrode 14 corresponding to an E-C-D section in Fig. 1B are shown by broken line, and a potential distribution in an area corresponding to a B-C-D section in Fig. 1B is shown by solid line. Potential distribution pVH is a potential distribution resulting when the gate voltage VG is the H level voltage VH, and pVL is a potential distribution resulting when the gate voltage VG is the L level voltage VL.

Fig. 6B shows potential distributions in the case where the drain voltage is the H level voltage VD1. Also, Fig. 6A shows a relationship between the gate voltage VG and the output voltage Vout when the drain voltage is the H level voltage VD1. In Fig. 6A, the solid lines show logarithmic conversion characteristics, and the broken line shows a linear conversion characteristic.

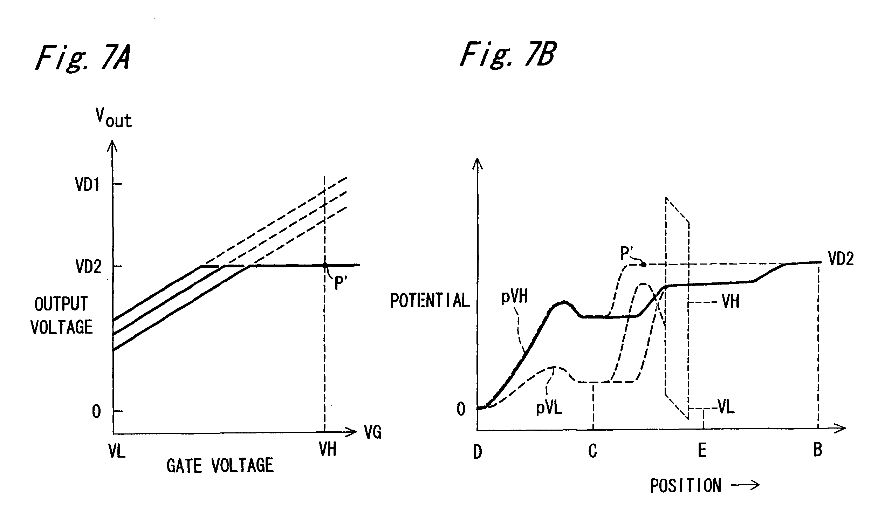

Also in Fig. 7B, a potential distribution in the area under the gate electrode 14 corresponding to the E-C-D section in Fig. 1B in the case where the drain voltage is the L level voltage VD2 is shown by broken line, and a potential distribution in the area corresponding to the B-C-D section in Fig. 1B in the case where the drain voltage is the L level voltage VD2 is shown by solid line. Reference character pVH denotes a potential distribution resulting when the gate voltage VG is the H level voltage VH, and pVL denotes a potential distribution resulting when the gate voltage VG is the L level voltage VL. Also, Fig. 7A shows a relationship between gate voltage VG and output voltage Vout obtained when the drain voltage is the L level voltage VD2.

As shown in Fig. 6B, on condition that the drain voltage is the H level voltage VD1 and the gate voltage VG is the H level voltage VH, the channel potential is P. Next, when the drain voltage is changed to the L level voltage VD2 that is lower than P, the channel 17 is charged until the voltage VD2 is reached, so that the channel potential becomes P' as shown in Fig. 7B. That is, the channel surface is pinned. As a result of this, generation of dark currents at the channel surface is suppressed.

Accordingly, if the drain driver circuit 45 applies the H level voltage VD1 only to the signal lines 42a, 42b, 42c of read-object rows in the read periods Ta, Tb, Tc, respectively, as shown in the lower half of Fig. 9, the drain voltage is maintained at the L level voltage VD2 for most part of the periods in the individual pixels 110, with the channel 17 in the pinned state. Therefore, setting the drain voltage to the H level voltage VD1 only for the read period of selected pixels 110 allows the potential distribution state of from the hole pocket 18 to the substrate 11 to remain almost unchanged against the change of the drain voltage from the L level voltage VD2 to the H level voltage VD1. Thus, while the drain voltage is the H level voltage VD1, the photocurrent can be made to steadily flow from the hole pocket 18 serving as a signal storage region to the substrate 11 so that the channel potential P can be read out as an output voltage Vout. That is, an output voltage Vout as an output signal that is obtained from logarithmic conversion of the photocurrent can be read out correctly.

As shown above, according to the third embodiment, dark currents at the surface of the normally depleted channel 17 under the ring-shaped gate electrode 14 can be suppressed.

(Fourth Embodiment)

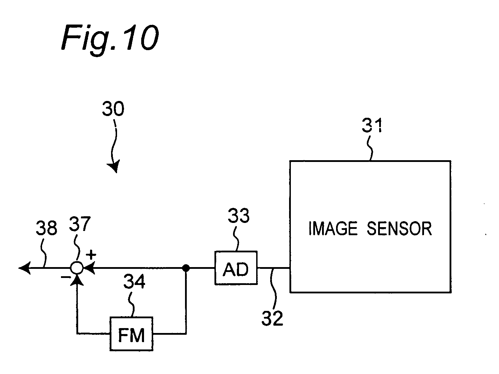

Next, Fig. 10 shows a fourth embodiment of the solid-state image pickup device of the present invention. The solid-state image pickup device of the fourth embodiment is implemented by a solid-state image pickup circuit 30 including an image sensor 31 which is constituted as in the second embodiment or third embodiment described above, an A/D converter 33, a frame memory 34 as a storage part, and a differential circuit 37 as a subtraction part.

In the solid-state image pickup circuit 30, an output line 32 through which the image sensor 31 produces an output signal is connected to the A/D converter 33, and the output side of the A/D converter 33 is connected to the differential circuit 37 and the frame memory 34. Also, the output side of the frame memory 34 is connected to the differential circuit 37.

The output signal produced by the image sensor 31 is converted into a digital signal by the A/D converter 33, and entered into the differential circuit 37 and the frame memory 34.

The frame memory 34 holds, from pixel to pixel, signals which resulted from the conversion of output signals of the image sensor 31 into digital signals by the A/D converter 33, the output signals being logarithmically converted photoelectric conversion signals produced under a condition that individual pixels are irradiated with light at a specified uniform intensity. That is, offset variations $\Delta Vij$ have been recorded on a pixel basis in the frame memory 34.

Accordingly, the differential circuit 37 is supplied with not only digital signals into which output signals read out in any arbitrary frame from the image sensor 31 have been converted by the A/D converter 33, but also offset variations $\Delta Vij$ on the pixel basis from the frame memory 34. The differential circuit 37 subtracts the pixel-to-pixel offset variations $\Delta Vij$ from the output signals in association with the individual pixels, and outputs an after-subtraction signal to an output line 38. As a result of this, the offset variations $\Delta Vij$ are canceled from all the frame signals (i.e., logarithmically converted photoelectric conversion signals), so that an image signal free from fixed pattern noise is obtainable from the output line 38.

Thus, according to the fourth embodiment, occurrence of fixed pattern noise due to pixel-to-pixel offset variations can be prevented in cases where the solid-state image pickup device has an image sensor 31 that performs logarithmic-conversion operation without involving reset operation.

Embodiments of the invention being thus described, it will be obvious that the same may be varied in many ways. Such variations are not to be regarded as a departure from the spirit and scope of the invention, and all such modifications as would be obvious to one skilled in the art are intended to be included within the scope of the following claims.

**Claims**

1. A solid-state image pickup device comprising:

   at least one pixel (101, 110) having a photodetection diode (111), a signal storage region (18) for storing therein signal charge derived from the photodetection diode, an insulated-gate field effect transistor (112) for reading, as an output signal, a channel potential which varies depending on a charge amount present in the signal storage region, and a substrate (11) which serves as a discharge destination of the charge present in the signal storage region; and a voltage generation part (51, 71) for applying a specified gate voltage and drain voltage to a gate (14) and a drain (16), respectively, of the insulated-gate field effect transistor (112) to balance a photocurrent generated at the photodetection diode (111) and a current discharged to the substrate (11) with each other at least during a signal read of the pixel so that the pixel (101, 110) is kept in a steady-state operating status that the photocurrent is flowing to the substrate (11) via the signal storage region (18) steadily.

2. The solid-state image pickup device as claimed in Claim 1, including a plurality of the pixels that are two-dimensionally arrayed,
   wherein the voltage generation part (71):

   in a non-read period, gives a first potential as a gate voltage to the gates (14) of the insulated-gate field effect transistors (112) of all the pixels (110) so that all the pixels are brought into the steady-state operating status, and
   in a read period, gives the first potential as a gate voltage to the gates (14) of the insulated-gate field effect transistors (112) of pixels of a selected row, and moreover gives a second potential as a gate voltage to the gates of the insulated-gate field effect transistors of pixels of non-selected rows, thereby making only the pixels of the selected row readable.

3. The solid-state image pickup device as claimed in Claim 2, wherein the first potential given to the gate (14) by the voltage generation part (51) has a value that causes the insulated-gate field effect transistor (112) to be turned on, and
   the second potential given to the gate by the voltage generation part (51) has a value that causes the insulated-gate field effect transistor (112) to be turned off.

4. The solid-state image pickup device as claimed in Claim 1, wherein the photodetection diode (111) is a buried photodiode.

5. The solid-state image pickup device as claimed in Claim 2, wherein the voltage generation part (51):

   in the non-read period, gives a third potential as a drain voltage to the drains (16) of the insulated-gate field effect transistors (112) of all the pixels (110), and
   in the read period, gives a fourth potential as a drain voltage to the drains (16) of the insulated-gate field effect transistors (112) of the pixels (110) of the selected row, and moreover gives the third potential as a drain voltage to the drains (16) of the insulated-gate field effect transistors (112) of the pixels (110) of the non-selected rows.

6. The solid-state image pickup device as claimed in Claim 5, wherein the third potential has a value that causes a channel surface under the gate (14) of the insulated-gate field effect transistor (112) to be charged and pinned, and

the fourth potential has a value that causes the channel surface under the gate of the insulated-gate field effect transistor to be depleted.

7. The solid-state image pickup device as claimed in any one of Claims 2 - 6, further comprising:

a storage part (34) for storing each of output signals derived from the plurality of pixels (110) in a dark state or while the plurality of pixels are irradiated with specified uniform light, and outputting the output signals as reference signals; and

a subtraction part (37) for subtracting, from each of output signals outputted from the pixels during an image pickup time, a corresponding reference signal, and then outputting the thus obtained signals as image pickup signals of the pixels, respectively.

Fig. 1A

Fig. 1B

Fig. 1C

Fig. 1D

VOLTAGE
GENERATION
CIRCUIT

71

POTENTIAL

$I_{sub}$

VB

$\phi_x$

$I_p$

VD

0

D          C                    B

POSITION →

*Fig.2*

*Fig.3*

Fig.4

Fig. 5B

Fig. 5A

## Fig. 6A

$V_{out}$

VD1

OUTPUT
VOLTAGE

P

0

VL    VH    VG

GATE VOLTAGE

## Fig. 6B

P

VD1

POTENTIAL

pVH

VH

pVL

0    VL

D    C    E    B

POSITION→

EP 1 592 231 A1

*Fig. 7A*

*Fig. 7B*

## Fig.8

GATE DRIVER CIRCUIT — 44

DRAIN DRIVER CIRCUIT — 45

HORIZONTAL READING CIRCUIT — 47

VOLTAGE GENERATION CIRCUIT — 51

Fig.9

EP 1 592 231 A1

# Fig.10

Fig. 11A PRIOR ART

Fig. 11B PRIOR ART

513 611

612

514

516

515

518

512
513
516
517
Y

515

518
514
516

511

Y

## Fig. 12 PRIOR ART

## Fig. 13 PRIOR ART

**EP 1 592 231 A1**

<table>
<tr><td colspan="2" align="center">**European Patent Office**</td><td align="center">**EUROPEAN SEARCH REPORT**</td><td>Application Number<br>EP 05 25 1099</td></tr>
</table>

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,Y | PATENT ABSTRACTS OF JAPAN<br>vol. 1999, no. 12,<br>29 October 1999 (1999-10-29)<br>-& JP 11 195778 A (INO VISION KK),<br>21 July 1999 (1999-07-21)<br>* abstract; figures 7-9 * | 1 | H04N3/15 |
| Y | RICQUIER N ET AL INTERUNIVERSITY MICROELECTRONICS CENTER (IMEC): "PIXEL STRUCTURE WITH LOGARITHMIC RESPONSE FOR INTELLIGENT AND FLEXIBLE IMAGER ARCHITECTURES"<br>PROCEEDINGS OF THE EUROPEAN SOLID STATE DEVICE RESEARCH CONFERENCE. (ESSDERC). LEUVEN, SEPT. 14 -17, 1992, AMSTERDAM, ELSEVIER, NL,<br>vol. CONF. 22,<br>14 September 1992 (1992-09-14), pages 631-634, XP000357124<br>* paragraphs [0002], [0003]; figure 2 * | 1 | |
| A | NICO RICQUIER ET AL: "Addresable Imager with a logarithmic Response for Machine Vision"<br>IMEKO. TECHNICAL COMMITTEE ON MEASUREMENT OF ELECTRICAL QUANTITIES. INTERNATIONAL SYMPOSIUM ON INTELLIGENT INSTRUMENTATION FOR REMOTE AND ON-SITE MEASUREMENTS,<br>12 May 1993 (1993-05-12), pages 453-457, XP002086881<br>* abstract * | 1 | TECHNICAL FIELDS SEARCHED (Int.Cl.7)<br><br>H04N |
| A | PATENT ABSTRACTS OF JAPAN<br>vol. 2003, no. 04,<br>2 April 2003 (2003-04-02)<br>& JP 2002 353433 A (CANON INC),<br>6 December 2002 (2002-12-06)<br>* abstract * | 1-7 | |

-/--

The present search report has been drawn up for all claims

| Place of search | Date of completion of the search | Examiner |
|---|---|---|
| The Hague | 9 September 2005 | Wahba, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

22

**European Patent Office**

**EUROPEAN SEARCH REPORT**

Application Number

EP 05 25 1099

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | HYNECEK J: "BCMD-AN IMPROVED PHOTOSITE STRUCTURE FOR HIGH-DENSITY IMAGE SENSOR" IEEE TRANSACTIONS ON ELECTRON DEVICES, IEEE INC. NEW YORK, US, vol. 38, no. 5, May 1991 (1991-05), pages 1011-1020, XP000200655 ISSN: 0018-9383 * the whole document * ----- | 1-7 | |
| A | US 2002/024071 A1 (KAWAJIRI KAZUHIRO ET AL) 28 February 2002 (2002-02-28) * figure 4a * ----- | 1-7 | |

TECHNICAL FIELDS SEARCHED (Int.Cl.7)

The present search report has been drawn up for all claims

| Place of search | Date of completion of the search | Examiner |
|---|---|---|
| The Hague | 9 September 2005 | Wahba, A |

EPO FORM 1503 03.82 (P04C01)

**EP 1 592 231 A1**

## ANNEX TO THE EUROPEAN SEARCH REPORT
## ON EUROPEAN PATENT APPLICATION NO.

EP 05 25 1099

This annex lists the patent family members relating to the patent documents cited in the above-mentioned European search report.
The members are as contained in the European Patent Office EDP file on
The European Patent Office is in no way liable for these particulars which are merely given for the purpose of information.

09-09-2005

| Patent document cited in search report | | Publication date | Patent family member(s) | | Publication date |
|---|---|---|---|---|---|
| JP 11195778 | A | 21-07-1999 | JP | 2935492 B2 | 16-08-1999 |
| | | | CN | 1495873 A | 12-05-2004 |
| | | | CN | 1241037 A ,C | 12-01-2000 |
| | | | EP | 0978878 A2 | 09-02-2000 |
| | | | HK | 1024103 A1 | 12-11-2004 |
| | | | KR | 2000010501 A | 15-02-2000 |
| | | | TW | 418533 B | 11-01-2001 |
| | | | US | 6051857 A | 18-04-2000 |
| | | | US | 6512547 B1 | 28-01-2003 |
| JP 2002353433 | A | 06-12-2002 | NONE | | |
| US 2002024071 | A1 | 28-02-2002 | JP | 3615144 B2 | 26-01-2005 |
| | | | JP | 2002164527 A | 07-06-2002 |
| | | | JP | 3568885 B2 | 22-09-2004 |
| | | | JP | 2002057316 A | 22-02-2002 |

EPO FORM P0459

For more details about this annex : see Official Journal of the European Patent Office, No. 12/82

24